Europäisches Patentamt

European Patent Office

Office européen des brevets

(19)

(11) **EP 0 750 339 A1**

(12) **DEMANDE DE BREVET EUROPEEN**

(43) Date de publication:
27.12.1996 Bulletin 1996/52

(51) Int Cl.6: **H01L 21/336**, H01L 21/265, H01L 29/10

(21) Numéro de dépôt: 96401334.6

(22) Date de dépôt: 19.06.1996

(84) Etats contractants désignés:
**DE FR GB IT NL**

(30) Priorité: **21.06.1995 FR 9507413**

(71) Demandeur: **COMMISSARIAT A L'ENERGIE ATOMIQUE**
**75015 Paris Cédex 15 (FR)**

(72) Inventeur: **Guegan, Georges**
**38180 Seyssins (FR)**

(74) Mandataire: **Dubois-Chabert, Guy**
**c/o BREVATOME**
**25, rue de Ponthieu**
**75008 Paris (FR)**

(54) **Procédé de fabrication de transistors**

(57)     Ce procédé comporte : une première implantation oblique d'ions (100) dans une première et une deuxième zone (144, 142), un masque (114) étant formé à la périphérie d'une troisième zone pour protéger la troisième zone des ions de la première implantation, une deuxième implantation oblique d'ions (130) dans les première et troisième zones, un masque (115) étant formé à la périphérie de la deuxième zone (142), pour protéger la deuxième zone (142) des ions (130) de la deuxième implantation, puis la formation d'une grille du transistor.

Application à la fabrication de transistors de type MOS, MIS, JFET ou bipolaires.

FIG. 5

FIG. 6

154  150  151  156

112  112

140  142

144  120

**Description**

Domaine technique

La présente invention concerne un procédé de réalisation d'un substrat semi-conducteur comportant une première, une deuxième et une troisième zones dopées juxtaposées, la première zone étant située entre la deuxième et la troisième zone et présentant une concentration moyenne de dopage supérieure à celle des deuxième et troisième zones.

L'invention trouve des applications dans les domaines de la microélectronique concernant la réalisation de circuits intégrés, et de transistors. Elle s'applique en particulier à la fabrication de transistors de type MOS (Metal Oxide Semiconductor), de structures de type CMOS (Complementary Metal Oxide Semiconductor), de transistors de type MIS, de transistors à effet de champ à jonction (JFET), et de transistors bipolaires.

Etat de la technique antérieure

Les performances en vitesse des circuits intégrés et des transistors, qui conditionnent aussi la bande passante en fréquences de ces dispositifs, dépendent notamment du courant que ceux-ci sont capables de délivrer, et de leur capacité de charge.

On entend par capacité de charge une capacité électrique comportant des capacités parasites de trois types différents. La capacité de charge comporte tout d'abord une capacité d'entrée intrinsèque de la (ou des) grille(s) active(s) du transistor ou du circuit intégré. Elle comporte ensuite une capacité parasite due aux lignes de connexion des composants, aux interconnexions entre les différentes parties des circuits et, pour les transistors, aux recouvrements des source et drain par la grille. La capacité de charge comporte enfin une capacité parasite due aux jonctions entre d'une part, la source et le drain des transistors et d'autre part les caissons du substrat dans lesquels sont réalisés ces transistors.

L'importance relative de la capacité de charge et de ses différentes composantes était faible devant celle de la capacité d'entrée intrinsèque des circuits ou assemblages anciens dont la dimension typique des composants était supérieure au micromètre.

A l'heure actuelle, avec la diminution de la taille des composants, l'importance relative des capacités parasites tend à augmenter. L'augmentation de la capacité parasite associée aux jonctions illustre cette tendance.

En effet, un dopage toujours plus élevé des substrats, nécessaire pour éviter les problèmes de perçage dans les circuits miniaturisés, augmente la capacité parasite des jonctions qui peut représenter de 20% à 30% de la capacité de charge totale, selon le type de circuit.

L'influence de cette capacité parasite sur les performances en vitesse des circuits est illustrée par exemple par le calcul du temps de multiplication simulé, avec un multiplieur de 16 bits par 16 bits de type CMOS

0,35μm. On constate dans cet exemple que lorsque les capacités parasites associées aux jonctions et aux lignes métalliques de connexion sont négligées, le temps de multiplication est de l'ordre de 4,6 ns. Par contre, lorsque les capacités parasites associées aux jonctions sont prises en compte, en négligeant les autres capacités parasites, le temps de multiplication augmente et passe à 5,5 ns.

Ainsi, la recherche de performances maximales en termes de vitesse des circuits conduit, d'une part, (comme indiqué ci-dessus) à augmenter le courant délivré par les transistors en réduisant, par exemple, les longueurs de leurs grilles et les épaisseurs des oxydes de grille, et d'autre part, à réduire les capacités parasites, notamment les capacités parasites des jonctions entre le caisson des transistors et les régions de source et de drain.

Une technique connue pour réduire les capacités des jonctions consiste à effectuer des implantations ioniques de fortes concentration dans le canal des transistors, sous la grille. On peut se reporter à ce sujet, aux documents (1) et (2) référencés à la fin de la présente description.

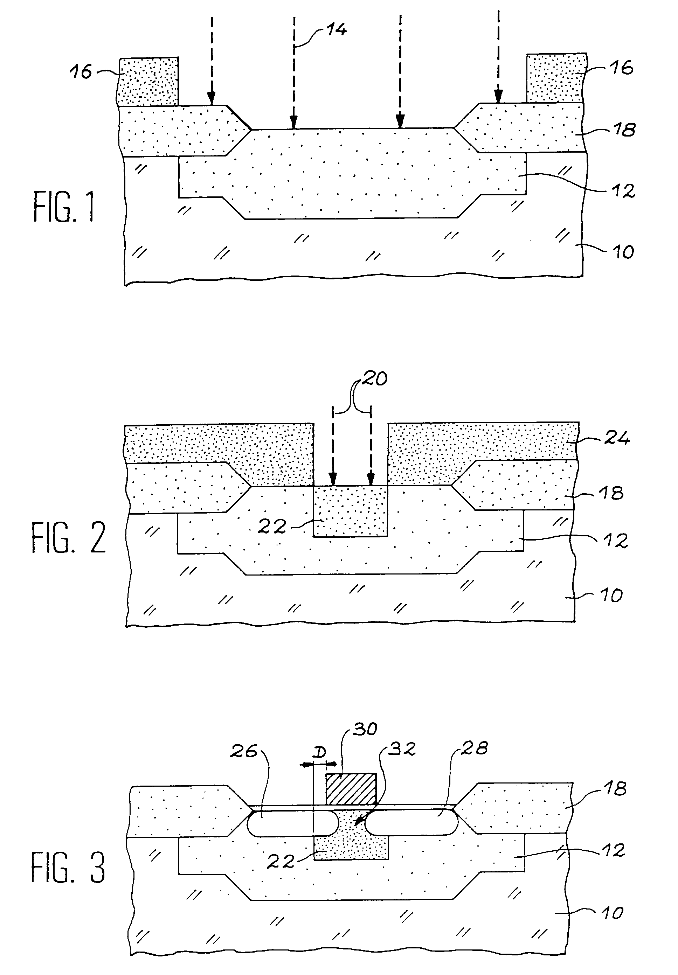

L'implantation ionique a pour but de réaliser un dopage du canal avec une forte concentration. Les figures 1 à 3 indiquent à titre d'illustration les différentes étapes de la fabrication d'un transistor d'une structure de type CMOS selon cette technique.

Comme le montre la figure 1, on forme tout d'abord dans un substrat 10 un caisson 12 par une implantation ionique désignée par la référence 14. Dans le cas de l'exemple décrit, le caisson 12 est de type p pour la réalisation d'un élément de type NMOS. Lors de l'implantation d'ions conduisant à un dopage de type p, un masque de résine 16 permet de protéger les autres parties du substrat (non représentées) dans lesquelles on souhaite réaliser des caissons de type n. A la surface du substrat 10, le caisson 12 est délimité et isolé par des pavés d'oxyde de champ 18.

Une deuxième implantation d'ions conduisant à un dopage de type p, désignée par la référence 20 sur la figure 2 est effectuée de façon localisée dans une région correspondant au canal 22 du transistor NMOS. Lors de cette implantation un masque 24 protège les futures régions de source et de drain, ainsi que d'éventuels caissons voisins de type n non visibles sur la figure. Bien entendu, pour la réalisation de transistors de type PMOS, les implantations 14 et 20 sont remplacées par des implantations d'ions conduisant à un dopage de type n. Les masques 16 et 24 permettent alors de protéger des caissons voisins de type p lors de ces implantations.

La fabrication se poursuit, comme le montre la figure 3 par la réalisation des sources, des drains et des grilles. Les sources 26 et les drains 28 sont réalisés par une implantation d'ions conduisant à un dopage de type n dans les caissons de type p et par une implantation d'ions conduisant à un dopage de type p dans les caissons de type n.

Cette opération nécessite donc pour chaque type de transistor NMOS ou PMOS une étape de formation de masque et une étape d'implantation ionique. Ceci permet d'optimiser séparément la fabrication des transistors par rapport aux contraintes liées à la réalisation du caisson et celles liées à la forme et aux dimensions du canal.

La technique décrite présente cependant un certain nombre de limitations liées pour l'essentiel au grand nombre d'étapes de fabrication, et notamment de formation de masques. Des difficultés apparaissent également en raison de l'alignement relativement critique entre la grille 30 et le canal 22. En effet, la précision de la superposition du motif de grille et du canal, ou du masque 24 définissant le canal, dépend essentiellement de l'outil de fabrication des transistors et donc de son prix. A titre d'exemple, le décalage entre la grille 30 et le canal 22, désigné par D sur la figure 3, peut varier de 20% à 40% de la longueur de la grille.

Un deuxième procédé de fabrication de transistors avec une capacité de charge réduite est décrit dans le document (3) référencé à la fin de la présente description. Selon ce document, la réduction des capacités des jonctions source/caisson et drain/caisson résulte de la formation du canal par épitaxie sélective après une implantation ionique de $BF_2$. Le profil de dopage, relativement abrupt, présente une concentration maximum ($N=1.0.10^{18}$) à une profondeur de 0,1 μm mesurée à partir de l'interface oxyde de grille-silicium. En dehors de cette région, la concentration de dopage est plus faible ($1.0.10^{16}$).

Ce procédé présente également un certain nombre de limitations. Parmi celles-ci on peut noter par exemple la création de défauts cristallins dans la zone de transition entre la région de silicium où est formé le transistor et les pavés d'oxyde de champ délimitant cette région. Par ailleurs, la mise en oeuvre du procédé est délicate. En particulier, le contrôle du dopage doit être très précis sous peine d'une dispersion importante des paramètres électriques des transistors réalisés. Enfin, la formation et la définition du canal par épitaxie sélective est une solution onéreuse pour la réalisation de dispositifs de type MOS.

Dans un troisième procédé connu de réalisation de transistors avec des faibles capacités parasites, le canal est défini par une implantation d'ions lourds. On peut se reporter à ce sujet aux documents (4) et (5) référencés à la fin de la présente description.

Conformément à ce procédé, le profil de dopage du canal des transistors est optimisé par une implantation d'ions lourds tels que des ions d'indium pour des transistors du type NMOS et des ions d'antimoine pour les transistors de type PMOS.

Ce procédé, plus simple à mettre en oeuvre que l'épitaxie sélective, comporte cependant des difficultés liées par exemple à l'activation de l'indium pour les fortes doses d'implantation.

La présente invention a pour but de proposer un procédé simple permettant de réaliser des transistors avec des capacités parasites réduites associées aux jonctions source/caisson et drain/caisson, et ne présentant pas les limitations évoquées ci-dessus.

Un but est également de proposer un transistor avec une concentration de dopage du caisson réduite dans les régions des jonctions source/caisson et drain/caisson.

De façon plus générale, un but de l'invention est de proposer un procédé, de mise en oeuvre simple, permettant la réalisation dans un substrat d'une zone fortement dopée et intercalée entre des zones plus faiblement dopées, en mettant à profit les possibilités offertes par les implanteurs ioniques actuels qui permettent d'implanter des ions avec un angle d'incidence important par rapport au substrat.

Les documents (6), (7) et (8) référencés à la fin de la présente description permettent de mieux comprendre les techniques d'implantation ionique oblique, c'est-à-dire avec un angle d'inclinaison par rapport à la surface du substrat.

Exposé de l'invention

Pour atteindre les buts exposés ci-dessus, l'invention a de façon générale pour objet un procédé de réalisation d'un transistor dans substrat semi-conducteur comportant une première, une deuxième et une troisième zones dopées juxtaposées comprenant respectivement le canal, la source et le drain du transistor, la première zone étant située entre la deuxième et la troisième zones et présentant une concentration moyenne de dopage supérieure à celle des deuxième et troisième zones, caractérisé en ce que le procédé comporte les étapes suivantes :

- première implantation oblique d'ions dans la première et la deuxième zone avec un premier angle d'implantation α, une première dose d'implantation D et une première énergie d'implantation E, un masque étant formé à la périphérie de la troisième zone en dehors des première, deuxième et troisième zones, ce masque présentant une épaisseur suffisante choisie en fonction du premier angle d'implantation α, de la première dose d'implantation D et de la première énergie d'implantation E pour protéger la troisième zone des ions de la première implantation,

- deuxième implantation oblique d'ions dans les première et troisième zones avec un deuxième angle d'implantation α', une deuxième dose d'implantation D' et une deuxième énergie d'implantation E', un masque étant formé à la périphérie de la deuxième zone, en dehors des première, deuxième et troisième zones, le masque présentant une épaisseur suffisante, choisie en fonction du deuxième angle d'implantation, de la deuxième dose d'implantation D' et de la deuxième énergie d'implantation pour protéger la deuxième zone des ions de la deuxième implantation,

- formation, après les première et deuxième implantations, d'une couche d'oxyde de grille et d'une grille au-dessus de la première zone et formation d'un drain et d'une source respectivement dans les deuxième et troisième zones,

les masques à la périphérie des deuxième et troisième zones, étant formés avant les première et deuxième implantations, les première et deuxième implantations étant effectuées avec des ions conduisant à un dopage d'un même type de conduction.

On entend par angle d'implantation l'angle que forme la direction d'implantation des ions par rapport à la normale à la surface du substrat semi-conducteur.

Selon un aspect de l'invention, les masques formés à la périphérie des deuxième et troisième zones peuvent être réalisés simultanément. Ces masques peuvent en particulier être formés dans une même couche de résine.

La couche d'oxyde de grille et la grille sont formées dans une étape postérieure aux première et deuxième implantations pour empêcher l'altération de ces parties sous l'effet des ions implantés.

Par ailleurs, il est possible aussi de réaliser les première et deuxième implantations avec des angles de même ouverture et de signe opposé, et avec des énergies égales. Dans ce cas, les masques formés à la périphérie des zones d'implantation ont préférentiellement des épaisseurs identiques.

Selon un aspect de l'invention,, les première et deuxième implantations peuvent être effectuées à travers une couche d'oxyde sacrificielle formée à la surface des premières, deuxième et troisièmes zones.

Dans une mise en oeuvre particulière préférée de l'invention, l'ouverture des angles d'implantation, l'énergie des implantations et la hauteur des masques peuvent être choisis de telle sorte que lors des première et deuxième implantations, les zones protégées par un masque présentent respectivement une longueur $L_1$ mesurée à partir de pavés d'oxyde de champ délimitant le transistor, et les zones implantées présentent une longueur $L_2$ telles que $L_2 > L_1$, $L_1$ et $L_2$ étant mesurées dans une direction d'écoulement des porteurs électriques (électrons ou trous) dans le transistor.

De même, l'ouverture des angles d'implantation, l'énergie des implantations et la hauteur des masques peuvent être choisies de telle sorte que la longueur $L_c$ de la première zone, comportant le canal du transistor est supérieure à la longueur $L_g$ d'une grille de ce transistor, les longueurs $L_c$ et $L_g$ étant mesurées dans un sens d'écoulement des porteurs dans le transistor.

D'autres caractéristiques et avantages de l'invention ressortiront de la description qui va suivre donnée à titre purement illustratif et non limitatif, en référence aux dessins annexés.

## Brève description des figures

- les figures 1 à 3, déjà décrites, sont des coupes transversales d'une partie d'une structure de type CMOS, et en particulier NMOS illustrant un procédé connu pour la réalisation d'une structure ayant un dopage plus faible dans les régions source et drain que dans la région du canal,
- les figures 4 et 5 sont des coupes transversales schématiques d'une partie d'un substrat, illustrant la formation dans ce substrat de zones dopées, conformément à la présente invention,
- la figure 6 est une coupe schématique transversale d'un transistor réalisé conformément à l'invention à partir du substrat de la figure 5,
- les figures 7 à 9 sont des coupes de parties de substrats semi-conducteurs traités conformément à l'invention, et illustrant le choix de paramètres d'implantation pour la mise en oeuvre du procédé de l'invention.

## Description détaillée de modes de mise en oeuvre de l'invention

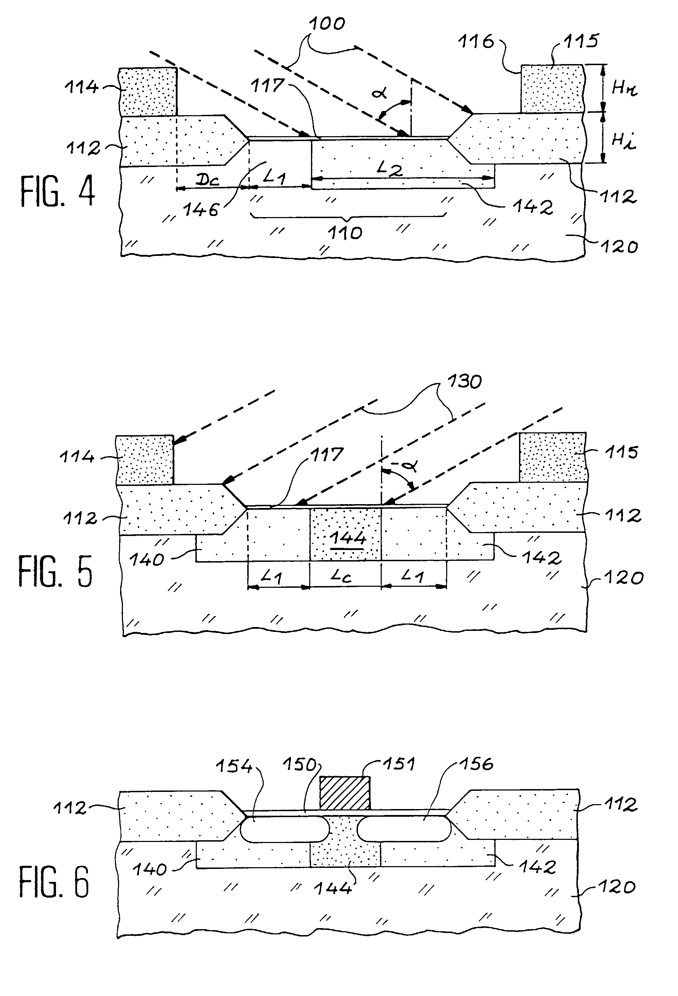

Comme le montre la figure 4, le procédé de l'invention comporte une première implantation d'ions 100 dans une partie 110, dite zone active, d'un substrat 120 dans laquelle on souhaite réaliser, par exemple un transistor d'un circuit de type CMOS. La partie 110 est délimitée par des pavés d'oxyde de champ 112. Dans le cas où, le substrat 120 est en silicium, il s'agit, par exemple, de pavés d'oxyde de silicium.

De préférence, on forme sur la surface de la zone active, une couche d'oxyde sacrificielle 117 avant de réaliser la première implantation. Cette couche permet la décanalisation des ions impolantés et évite que les ions implantés ne pénètrent trop loin dans le substrat. Elle sert également de protection contre d'éventuelles contaminations dues à l'implanteur. La couche 117, par exemple en $SiO_2$, est obtenue dans une atmosphère oxydante ou déposée à basse température, par exemple. Son épaisseur est choisie suffisamment fine pour ne pas masquer les implantations et suffisamment épaisse pour compenser d'éventuelles perturbations que sa réalisation induit dans le substrat. Son épaisseur est, par exemple de 20 nm.

La première implantation est réalisée avec des ions conduisant à un dopage d'un premier type de conductivité avec un premier angle d'implantation $\alpha$ défini par rapport à la normale à la surface du substrat 120 et avec une première énergie d'implantation. Le dopage peut être du type p, pour la réalisation d'un transistor de type NMOS et de type n, pour la réalisation d'un transistor de type PMOS. La première implantation, ainsi que les étapes suivantes du procédé, peuvent concerner un seul, mais aussi de préférence une pluralité de transistors fabriqués simultanément. A titre d'exemple, on implante des ions de bore pour un transistor NMOS avec une dose de quelques $10^{12}$at/cm$^2$ afin de former des zones dopées avec une concentration moyenne de quelques $10^{16}$at/cm$^3$. La dose est déterminée en fonction de la longueur de grille à réaliser.

Un masque 114, 115, avec une ouverture 116 en face de la zone 110, est formé sur les pavés d'oxyde de champ 112. Dans le cas de la figure 4, les parties de masque 114 et 115 formées de part et d'autre à la périphérie de la zone 110 sont réalisées simultanément dans une même couche de résine, et présentent donc une même épaisseur.

Lors de la première implantation, la partie de masque 114 arrête les ions 100 dans une zone 140 d'une longueur $L_1$ mesurée à partir du bord de l'oxyde de champ 112, de sorte que l'implantation n'a lieu que dans une zone 142 dont la longueur est désignée par $L_2$ sur la figure. Les longueurs $L_1$ et $L_2$ sont considérées dans le plan de coupe des figures qui correspond sensiblement à la direction d'écoulement des porteurs électriques dans la structure finalement réalisée. On désigne aussi par $D_c$ la distance séparant le bord de l'oxyde de champ tourné vers la région 140, et le bord du masque 114.

Pour modifier et ajuster les longueurs $L_1$ et $L_2$, il est possible d'agir notamment sur la hauteur du masque.

Comme le montre la figure 5, une deuxième implantation est, dans le cas de l'exemple décrit, réalisée avec un angle -$\alpha$ avec des ions 130 conduisant à un dopage du même type de conductivité, et avec une énergie identique à celle de la première implantation. La deuxième implantation est également effectuée à travers la couche sacrificielle 117. A titre d'exemple, la deuxième implantation peut être effectuée avec des ions de bore pour un transistor NMOS avec une dose de quelques $10^{12}$at/cm$^2$ pour former des zones dopées avec une concentration de quelques $10^{16}$at/cm$^3$. Cette deuxième implantation peut être réalisée de façon simple en faisant pivoter le substrat dans le dispositif d'implantation d'un angle de 180°.

Lors de la deuxième implantation, la partie de masque 115 joue un rôle comparable à celui de la partie de masque 114 lors de la première implantation. Le masque 115 arrête les ions d'implantation 130 dans une zone 142. Les ions 130 peuvent par contre atteindre la zone 140 qui était protégée par le masque 114 lors de la première implantation, ainsi qu'une zone 144. La zone 144, dont la longueur, considérée dans le plan de la figure, est désignée par $L_c$ sur la figure 5 est une zone qui a subi la première et la deuxième implantations d'ions. Elle n'a été protégée par aucune des parties de masque 114, 115. La concentration de dopage y est donc supérieure à celle des zones 140 et 142. Pour des raisons de symétrie respectée dans l'exemple de mise en oeuvre décrit, la zone 142 présente également une longueur L1 mesurée à partir de l'oxyde de champ 112 qui la borde. On note également que les zones dopées 140 et 142 s'étendent sous les pavés d'oxyde de champ, sur une certaine longueur. Par ailleurs, en raison du caractère oblique des implantations les interfaces entre les différentes zones dopées ont un profil biseauté.

Après les première et deuxième implantations, la couche sacrificielle 117 est éliminée.

Les zones 140, 142 et 144 formées dans le substrat 120 servent, comme le montre la figure 6, à la réalisation d'un transistor. Ces zones peuvent en effet comporter la source, le drain et le canal d'un transistor. La zone 144 correspond au canal qui présente la plus forte concentration de dopage. Les source et drain peuvent être respectivement et indifféremment formés dans les zones 140 et 142, plus faiblement dopées.

Une couche 150, dite d'oxyde de grille et formée à la surface du substrat 120 dans la zone 110, puis une grille 151 est formée sur cette couche 150 au-dessus de la zone 144. La grille est formée conformément à des procédés de lithographie et de gravure connus en soi. De même, une source 154 et un drain 156 sont formés de part et d'autre de la grille 151, dans les zones 140 et 142 par implantation d'ions conduisant à un dopage d'un type de conductivité opposé à celui obtenu avec les ions des première et deuxième implantations. Dans le cas d'un transistor de type NMOS, le drain et la source sont de type n. L'implantation des source et drain est réalisée usuellement de façon sensiblement perpendiculairement au substrat 120. On peut noter que la formation de la grille et des zones de source et de drain est postérieure aux étapes d'implantation oblique.

Les étapes de fabrication de la grille et d'implantation des source et drain sont identiques à celles que l'on effectue pour les transistors (NMOS) de type connu. On peut se reporter à ce sujet, par exemple au document (9) référencé à la fin de la présente description.

La hauteur du masque de résine 114, 115, la dose, l'énergie et les angles des implantations sont choisis de sorte que lors des première et deuxième implantations, la longueur des régions implantées $L_2$ soit supérieure à la longueur $L_1$.

Par ailleurs, pour la réalisation d'un transistor conforme à la figure 6 on vérifie la relation suivante :

$$L_c = L_2 - L_1 - D_c \geq L_g$$

où $L_g$ est la longueur de la grille entre la source et le drain.

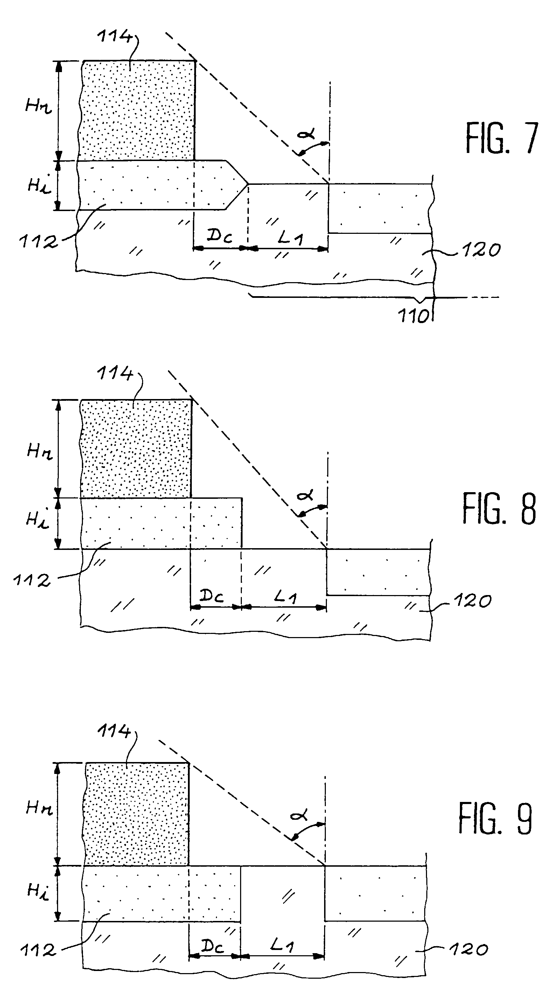

Les figures 7, 8 et 9 permettent de montrer plus précisément les paramètres qui caractérisent les implantations ioniques obliques, conformément à l'invention. On retrouve sur les figures 7, 8 et 9 qui correspondent à des vues partielles de la figure 6, des éléments ou parties identiques ou similaires à ceux des figures 5 et 6. Ces éléments ou parties portent les mêmes références que sur ces figures et on pourra, à leur sujet, se reporter à la description qui précède.

La figure 7 donne un exemple où le pavé d'oxyde de champ 112 est semi-enterré dans le substrat 120. La figure 8 illustre le cas où le pavé d'oxyde de champ 112 est non-enterré, tandis que la figure 9 montre un pavé d'oxyde de champ 112 complètement enterré dans le substrat. A ces trois situations on associe respectivement un paramètre $K_1$ tel que $K_1 = 1$ pour un pavé d'oxyde de champ non-enterré, $K = 0,5$ pour un pavé d'oxyde de champ semi-enterré et $K = 0$ pour un pavé d'oxyde de champ enterré.

Sur les figures, $H_i$ et $H_r$ désignent par ailleurs respectivement la hauteur du pavé d'oxyde de champ et celle du masque de résine 114.

La longueur totale de la zone active 110 est égale à la somme de la longueur du canal désignée par $L_c$ et des longueurs des sources de drain désignées respectivement par $L_1 S$ et $L_1 D$. Ainsi, en considérant que les longueurs $L_1 S$ et $L_1 D$ sont sensiblement égales à la longueur $L_1$ définie ci-dessus, la hauteur du masque $H_r$ est liée à l'angle $\alpha$ de l'implantation ionique oblique par la relation suivante :

$$H_r = (D_c + L_1)/\mathrm{tg}\alpha - K_1 H_i$$

dans laquelle $D_c$ représente, comme dans ce qui précède, la distance entre le bord de la zone active (et du pavé d'oxyde) et le bord du masque.

Comme l'indique le document (10) référencé à la fin de la présente description, dans le cas d'une jonction abrupte formée par un dopage par implantation verticale constante, la capacité de jonction source/caisson ou drain/caisson calculée par unité de surface s'exprime sous la forme suivante :

$$Cj = Cjo/(V + \phi_{diff})^{1/2}$$

où V représente la tension appliquée sur la jonction, $\phi_{diff}$ la tension de diffusion de la diode avec :

$$Cjo = (q\varepsilon_0 \varepsilon_{Si} N/2)^{1/2}$$

où $\varepsilon_0 \varepsilon_{Si}$ représente la permittivité du silicium, q la charge de l'électron et N le dopage moyen du caisson.

Aussi, on constate que par rapport à une structure de type CMOS connue, le procédé de l'invention permet de diviser par 1,414 les capacités parasites associées aux jonctions source/caisson et drain/caisson quel que soit le type de transistor (NMOS ou PMOS) et ce sans augmentation du nombre d'étapes de fabrication.

A titre d'exemple, pour un circuit CMOS de type 0,35 µm présentant une concentration de dopage moyenne de $1.10^{17} \mathrm{cm}^{-3}$ dans la région de canal, fixée par rapport à des critères de résistance au perçage, la capacité surfacique des jonctions est de 1,08 fF/µm², dans le cas d'une fabrication conventionnelle.

Dans le cas d'une fabrication conforme à l'invention, la concentration de dopage sous les jonctions de source et de drain est réduite à $5,0.10^{16} \mathrm{cm}^{-3}$ et la capa-cité surfacique est de l'ordre de 0,76 fF/µm².

Dans l'exemple ci-dessus, la hauteur du masque de résine pour les première et deuxième implantations est de 1,6 µm. Elle est calculée à partir des valeurs suivantes :

-   $\alpha = 45°$ (angle de l'implantation ionique oblique),
-   $H_i = 0,40$ µm (hauteur de l'isolant de champ),
-   $D_c = 0,8$ µm,
-   $L_1 = 1,0$ µm (longueur de la région de source ou de drain).

Finalement, grâce à l'invention il est possible de réaliser de façon simple des circuits, et en particulier des transistors, avec de faibles capacités parasites. Ces circuits ou ces transistors sont donc plus rapides. Le procédé de l'invention peut être utilisé très largement pour la fabrication de transistors MOS, tels que décrits ci-dessus, mais aussi pour la fabrication de transistors de type MIS, JFET ou bipolaires.

## DOCUMENTS CITES DANS LA PRESENTE DESCRIPTION

(1)
K.F. LEE et al.
"Room Temperature 0.1µm CMOS Technology with 11.8 ps Gate Delay", Tech. Digest, IEDM 1993, pp. 131-134

(2)
M. YOSHIMI et al.
"Study of the operation speed of half-micron design rule CMOS Ring oscillators", Electronics Letters, vol. 24, N°3, February 1988

(3)
K. NODA et al.
"0.1µm Delta-doped MOSFET using post low-energy implanting selective epitaxy", Symposium on VLSI Technology Digest of Technical Papers, 1994, pp. 19-20

(4)
G.G. SHAHIDI et al.
"High-Performance devices for a 0.15µm CMOS Technology", IEEE Electron Device Letters, vol. 14, N° 10, October 1993

(5)
T. SKOTNICKI et al.
"Channel Engineering by heavy ion implants", ESSDERC'94, Tech. Digest, pp. 671-674

(6)
T. HORI
"1/4 µm LATID (LArge-Tilt-angle Implanted-Drain) Technology for 3.3 V Operation" IEDM 1989, Tech. Digest, pp. 777-780

(7)
T. HORI, K. KURIMOTO
"A New Half-micron p-Channel MOSFET with LATIPS (LArge-Tilt-angle Implanted Punchthrough Stopper)", IEDM 1988, Tech. Digest, pp. 394-397

*(8)*

R.B. SIMONTON, D.E. KAMENITSA, A.M. RAY
"Process Control Issues for Ions Implantation Using Large Tilt Angles and Wafer Repositioning", Solid State Technology, November 1992, pp. 29-38

*(9)*

Semiconductor Device Modeling with SPICE Editor Paolo Antognetti, Mc Graw-Hill International Editions

*(10)*

A.S. GROVE
"Physics and Technology of semiconductor devices", John Wiley and Sons - New York 1967

## Revendications

1. Procédé de réalisation d'un transistor dans un substrat semi-conducteur (120) comportant une première (144), une deuxième (142) et une troisième (140) zones dopées juxtaposées comprenant respectivement le canal (144), la source (154) et le drain (156) du transistor, la première zone (144) étant située entre la deuxième (142) et la troisième (140) zones et présentant une concentration moyenne de dopage supérieure à celle des deuxième (142) et troisième (140) zones, caractérisé en ce que le procédé comporte les étapes suivantes :

   - première implantation oblique d'ions (100) dans la première et la deuxième zone avec un premier angle d'implantation ($\alpha$), une première dose d'implantation D et une première énergie d'implantation (E), un masque (114) étant formé à la périphérie de la troisième zone (140) en dehors des première, deuxième et troisièmes zones, ce masque présentant une épaisseur suffisante choisie en fonction du premier angle d'implantation ($\alpha$), de la première dose (D) et de la première énergie d'implantation (E) pour protéger la troisième zone (140) des ions (100) de la première implantation,
   - deuxième implantation oblique d'ions (130) dans les première (144) et troisième (140) zones avec un deuxième angle d'implantation ($\alpha'$), une deuxième dose d'implantation (D') et une deuxième énergie d'implantation (E'), un masque (115) étant formé à la périphérie de la deuxième zone (142), en dehors des première, deuxième et troisième zones, le masque présentant une épaisseur suffisante, choisie en fonction du deuxième angle d'implantation ($\alpha'$), de la deuxième dose D' et de la deuxième énergie d'implantation (E') pour protéger la deuxième zone des ions de la deuxième implantation,
   - formation après les première et deuxième implantations d'une couche d'oxyde de grille (150) et d'une grille au-dessus de la première zone (144) et formation d'un drain (156) et d'une source (154) dans les deuxième et troisième zones (142 ; 140),

   les masques (114, 115) à la périphérie des deuxième (142) et troisième (140) zones, étant formés avant les première et deuxième implantations et les première et deuxième implantations étant effectuées avec des ions conduisant à un dopage d'un même type de conduction.

2. Procédé selon la revendication 1, caractérisé en ce que les masques (114, 115) formés à la périphérie des deuxième (142) et troisième (140) zones, sont formés simultanément.

3. Procédé de réalisation d'un semi-conducteur selon la revendication 1, caractérisé en ce que les première et deuxième implantations sont effectuées à travers une couche d'oxyde sacrificielle (117) formée à la surface des première, deuxième et troisième zones.

4. Procédé selon la revendication 1, caractérisé en ce que les premier et deuxième angles d'implantation ($\alpha$, $\alpha'$) présentent une ouverture identique et un signe opposé, ($\alpha'=-\alpha$), que la première dose D et la deuxième dose d'implantation D' sont identiques, que les première (E) et deuxième (E') énergies d'implantation sont identiques (E=E') et en ce que les masques (114, 115) formés à la périphérie des deuxième (142) et troisième (140) zones présentent des épaisseurs identiques.

5. Procédé selon la revendication 1, caractérisé en ce que l'ouverture des angles d'implantation ($\alpha$, $\alpha'$), les doses d'implantation D et D', l'énergie des implantations (E, E') et la hauteur des masques (Hr) sont choisies de telle sorte que lors des première et deuxième implantations, les zones (142, 140) protégées par un masque (114, 115) présentent respectivement une longueur $L_1$ mesurée à partir des pavés d'oxyde (112) de champ délimitant le transistor, et les zones implantées présentent une longueur $L_2$ telles que $L_2>L_1$, $L_1$ et $L_2$ étant mesurées dans un sens d'écoulement de charges dans le transistor.

6. Procédé selon la revendication 1, caractérisé en ce que l'ouverture des angles d'implantation ($\alpha$, $\alpha'$), la dose d'implantation (D, D'), l'énergie des implantations (E, E') et la hauteur des masques (114, 115) sont choisies de telle sorte que la longueur $L_c$ de la première zone (144), comportant le canal du transistor est supérieure à la longueur $L_g$ d'une grille de ce transistor, les longueurs $L_c$ et $L_g$ étant mesurées dans un sens d'écoulement des porteurs dans le transistor.

FIG. 1

FIG. 2

FIG. 3

FIG. 4

FIG. 5

FIG. 6

114

$H_n$

$H_i$

112

$D_c$    $L_1$

α

FIG. 7

120

110

114

$H_n$

$H_i$

112

$D_c$    $L_1$

α

FIG. 8

120

114

$H_n$

$H_i$

112

$D_c$    $L_1$

α

FIG. 9

120

# EP 0 750 339 A1

Office européen
des brevets

**RAPPORT DE RECHERCHE EUROPEENNE**

Numero de la demande
EP 96 40 1334

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | PATENT ABSTRACTS OF JAPAN vol. 017, no. 518 (E-1434), 17 Septembre 1993 & JP-A-05 136403 (NIPPON STEEL CORP), 1 Juin 1993, * abrégé; figure 1 * | 1-5 | H01L21/336 H01L21/265 H01L29/10 |
| Y | DE-A-42 19 319 (GOLD STAR ELECTRONICS) 14 Janvier 1993 * colonne 4, ligne 38 - colonne 6, ligne 3; figure 4 * | 1-5 | |
| A | US-A-4 232 439 (SHIBATA HIROSHI) 11 Novembre 1980 * colonne 3, ligne 40 - ligne 63; figures 4,6 * | 1-3 | |
| A | IBM TECHNICAL DISCLOSURE BULLETIN, vol. 14, no. 11, Avril 1972, NEW YORK, US, page 3363 XP002000124 F.F. FANG ET AL: "Forming Double Diffused Regions." * page 3363 * | 1,2,4 | **DOMAINES TECHNIQUES RECHERCHES (Int.Cl.6)**  H01L |
| D,A | INTERNATIONAL ELECTRON DEVICES MEETING 1993. TECHNICAL DIGEST (CAT. NO.93CH3361-3), PROCEEDINGS OF IEEE INTERNATIONAL ELECTRON DEVICES MEETING, WASHINGTON, DC, USA, 5-8 DEC. 1993, ISBN 0-7803-1450-6, 1993, NEW YORK, NY, USA, IEEE, USA, pages 131-134, XP002000125 LEE K F ET AL: "Room temperature 0.1 mu m CMOS technology with 11.8 ps gate delay" * page 131, colonne de droite * | 1,3,6 | |

-/--

Le présent rapport a été établi pour toutes les revendications

| Lieu de la recherche | Date d'achèvement de la recherche | Examinateur |
|---|---|---|
| LA HAYE | 12 Septembre 1996 | Gélébart, J |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.......................................................
& : membre de la même famille, document correspondant

EPO FORM 1503 03.82 (P04C02)

13

**Office européen des brevets**

## RAPPORT DE RECHERCHE EUROPEENNE

Numero de la demande

EP 96 40 1334

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US-A-4 701 775 (COSENTINO STEPHEN J ET AL) 20 Octobre 1987<br>* colonne 2, ligne 15 - colonne 3, ligne 13; figures 1,2 *<br>----- | 3 | |
| | | | **DOMAINES TECHNIQUES RECHERCHES (Int.Cl.6)** |

Le présent rapport a été établi pour toutes les revendications

| Lieu de la recherche | Date d'achèvement de la recherche | Examinateur |
|---|---|---|
| LA HAYE | 12 Septembre 1996 | Gélébart, J |

EPO FORM 1503 03.82 (P04C02)